# EUROPEAN PATENT APPLICATION

(11) **EP 4 726 961 A1**
(43) Date of publication of application: **15.04.2026**
(21) Application number: 25205782.3
(22) Date of filing: 30.09.2025
(51) Int. Cl.: H02J 7/44, H02J 7/46, H02J 7/50

(54) **BATTERY MANAGEMENT SYSTEM, ENCODING METHOD FOR BATTERY MANAGEMENT SYSTEM, AND ELECTRONIC DEVICE**

(30) Priority: 11.10.2024 CN 202411418786
(71) Applicant: AESC Japan Ltd., Yokohama-shi, Kanagawa 220-0012 (JP)
(72) Inventor: LI, Zhanwen, 201315 Pudong New Area Shanghai (CN); SONG, Zhongqi, 201315 Pudong New Area Shanghai (CN)
(74) Representative: Becker, Eberhard

(57) **Abstract**

Disclosed are a battery management system, an encoding method for the battery management system, and an electronic device. The battery management system includes: a battery management control panel (BMC) and at least two battery cell sampling control panels (CMC, CMC1-CMCN). Each of the battery cell sampling control panels (CMC, CMC1-CMCN) includes a bridge chip. The battery management control panel (BMC) is configured to send a first level signal to a GPIO port (GPIO0-GPIO4) of the bridge chip contained in each battery cell sampling control panel (CMC, CMC1-CMCN) to change an ID status of an ID port of the battery cell sampling control panel (CMC, CMC1-CMCN). The first level signal sent by the battery management control panel (BMC) to each of the battery cell sampling control panels (CMC, CMC1-CMCN) is different from one another. The ID status represents a unique identifier of the battery cell sampling control panel (CMC, CMC1-CMCN).

## Description

### BACKGROUND

### Technical Field

The present disclosure relates to encoding battery management systems, and particularly relates to a battery management system, an encoding method for a battery management system, and an electronic device.

### Description of Related Art

A battery management system (BMS) typically employs a distributed architecture, wherein a battery cell sampling control panel and a battery management control panel are separate components. The communication methodology between the battery cell sampling control panel and the battery management control panel constitutes a critical element for implementing battery pack monitoring and control functions. Given that the battery management control panel and the battery cell sampling control panel generally communicate with each other through a CAN (controller area network) bus, and where the quantity of battery cell sampling control panel is more than one unit, each battery cell sampling control panel has to have a unique identifier (ID) to ensure that signals transmitted by the battery management control panel are correctly received by the appropriate battery cell sampling control panel. Consequently, encoding of multiple battery cell sampling control panels is required to distinguish between different battery cell sampling control panels. Existing technology typically relies upon a hardware state of battery cell sampling control panels to differentiate between different battery cell sampling control panels, thereby implementing encoding of the battery cell sampling control panels. However, configuring hardware states substantially increases hardware development costs for battery cell sampling control panels, and such hardware state configuration needs to be implemented by specialized technical personnel, the operations are cumbersome and prone to error.

### SUMMARY

The technical problem to be solved by the present disclosure is to overcome the defects in the existing technology that encoding requires different configurations of the hardware status of the battery cell sampling control panel, resulting in high costs and high error rates, and to provide a battery management system, an encoding method for a battery management system, and an electronic device.

The present disclosure solves the above technical problems through the following technical solutions:
In a first aspect, a battery management system is provided. The battery management system includes: a battery management control panel and at least two battery cell sampling control panels. The battery management control panel is connected with each of the battery cell sampling control panels respectively. Each of the battery cell sampling control panels includes a bridge chip.

The battery management control panel is configured to send a first level signal to a GPIO (General-purpose Input/Output) port of the bridge chip contained in the battery cell sampling control panel to change an ID (identification) status of an ID port of the battery cell sampling control panel. The first level signal sent by the battery management control panel to each of the battery cell sampling control panels is different from one another. The ID status represents a unique identifier of the battery cell sampling control panel.

Optionally, the battery management control panel is connected with each of the battery cell sampling control panels respectively through a CAN bus. The battery management control panel sends the first level signal to the GPIO port of the bridge chip contained in the battery cell sampling control panel through the CAN bus.

Optionally, the battery management control panel is also connected with one battery cell sampling control panel through a wakeup signal line. After the battery management control panel sends a wakeup signal to the bridge chip of the battery cell sampling control panel connected with the battery management control panel through the wakeup signal line, the battery management control panel sends the first level signal to the bridge chip of the awakened battery cell sampling control panel.

And/Or, two adjacent battery cell sampling control panels are connected through the wakeup signal line. After the battery management control panel sends the wakeup signal to the bridge chip of one battery cell sampling control panel among the other battery cell sampling control panels through the wakeup signal line, the battery management control panel sends the first level signal to the bridge chip of the awakened battery cell sampling control panel. The other battery cell sampling control panels are battery cell sampling control panels among the at least two battery cell sampling control panels except for the battery cell sampling control panel connected with the battery management control panel.

Optionally, the battery cell sampling control panel is configured to feed back the ID status to the battery management control panel through the CAN bus. The battery management control panel is also configured to store the ID status fed back by the battery cell sampling control panel.

And/Or, before sending the first level signal to the GPIO port of the bridge chip contained in the battery cell sampling control panel, the battery management control panel is also configured to send a same second level signal to the GPIO port of the bridge chip contained in each of the battery cell sampling control panels to initialize the ID status of the ID port of each of the battery cell sampling control panels.

Optionally, in response to duplication of the ID status fed back by the battery cell sampling control panel, the battery management control panel re-executes the step of sending the first level signal to the GPIO port of the bridge chip contained in the battery cell sampling control panel to achieve re-encoding of the battery cell sampling control panel.

In a second aspect, an encoding method for a battery management system is provided, which is applied to a battery management control panel contained in the battery management system. The battery management system further includes: at least two battery cell sampling control panels. The battery management control panel is connected with each of the battery cell sampling control panels respectively. The encoding method includes the following steps:
sending a first level signal to a GPIO port of a bridge chip contained in the battery cell sampling control panel to change an ID status of an ID port of the battery cell sampling control panel;
wherein, the first level signal sent to each of the battery cell sampling control panels is different from one another. The ID status represents a unique identifier of the battery cell sampling control panel.

Optionally, the step of sending the first level signal to the GPIO port of the bridge chip contained in the battery cell sampling control panel includes: sending a same second level signal to the GPIO port of the bridge chip contained in the battery cell sampling control panel to initialize the ID status of the ID port of each of the battery cell sampling control panels; sequentially sending the first level signal to the GPIO port of the bridge chip contained in the battery cell sampling control panel.

And/Or, the step of sending the first level signal to the GPIO port of the bridge chip contained in the battery cell sampling control panel includes: sequentially waking up one bridge chip, sending the first level signal to the GPIO port of the bridge chip contained in the awaken battery cell sampling control panel.

And/Or, the encoding method further includes: receiving the ID status fed back by each of the battery cell sampling control panels, in response to a presence of the same ID status, re-executing the step of sending the first level signal to the GPIO port of the bridge chip contained in the battery cell sampling control panel.

In a third aspect, an encoding method for a battery management system is provided, which is applied to a battery cell sampling control panel contained in the battery management system. The battery cell sampling control panel includes a bridge chip. The battery management system further includes: a battery management control panel. The battery management control panel is connected with the battery cell sampling control panel. The encoding method includes the following steps:
receiving, by a GPIO port of the bridge chip, a first level signal sent by the battery management control panel to change an ID status of ab ID port of the bridge chip;
wherein, the first level signal sent by the battery management control panel to each of the battery cell sampling control panels in at least two battery cell sampling control panels contained in the battery management system is different from one another. The ID status represents a unique identifier of the battery cell sampling control panel.

Optionally, the encoding method further includes:
feeding back the ID status to the battery management control panel, so that the battery management control panel stores the ID status.

In a fourth aspect, an electronic device is provided, including a memory, a processor, and a computer program stored in the memory and configured for running on the processor, wherein in that the processor implements the encoding method for the battery management system in any one of the above embodiments when executing the computer program.

Based on common knowledge in the field, the above preferred conditions may be combined freely to obtain various preferred examples of the present disclosure.

The positive progressive effects of the present disclosure lie in: in the present disclosure, the battery cell sampling control panel includes a bridge chip. The battery management control panel changes the ID status of the ID port of each of the bridge chips by sending a first level signal, thereby encoding for each of the battery cell sampling control panels without requiring configuration of the hardware status of the battery cell sampling control panel, thus saving the labor cost of professional technicians configuring the hardware status, reducing the error rate of encoding the battery cell sampling control panel, and simultaneously reducing the manufacturing cost of the battery management system.

### BRIEF DESCRIPTION OF THE DRAWINGS

FIG. 1 is a structural schematic diagram of a battery management system provided in an exemplary embodiment of the present disclosure.
FIG. 2 is a structural schematic diagram of a bridge chip in a battery management system provided in an exemplary embodiment of the present disclosure.
FIG. 3 is an interaction diagram of a battery management control panel and a battery cell sampling control panel in a battery management system provided in an exemplary embodiment of the present disclosure.
FIG. 4 is a structural schematic diagram of an electronic device provided in an exemplary embodiment of the present disclosure.

### DESCRIPTION OF THE EMBODIMENTS

The present disclosure is further illustrated below through examples, but the present disclosure is not thereby limited to the scope of the described examples.

In the embodiments of the present disclosure, prefix words such as "first" and "second" are adopted merely to distinguish different described objects, and have no limiting effect on the position, order, priority, quantity, or content of the described objects. The use of ordinal numbers and other prefix words for distinguishing described objects in the embodiments of the present disclosure does not constitute limitations on the described objects. For statements regarding the described objects, reference should be made to the description in the context of the claims or embodiments, and no redundant limitations should be imposed due to the use of such prefix words. Furthermore, in the description of the present embodiment, unless otherwise specified, "multiple" means two or more.

### Embodiment 1

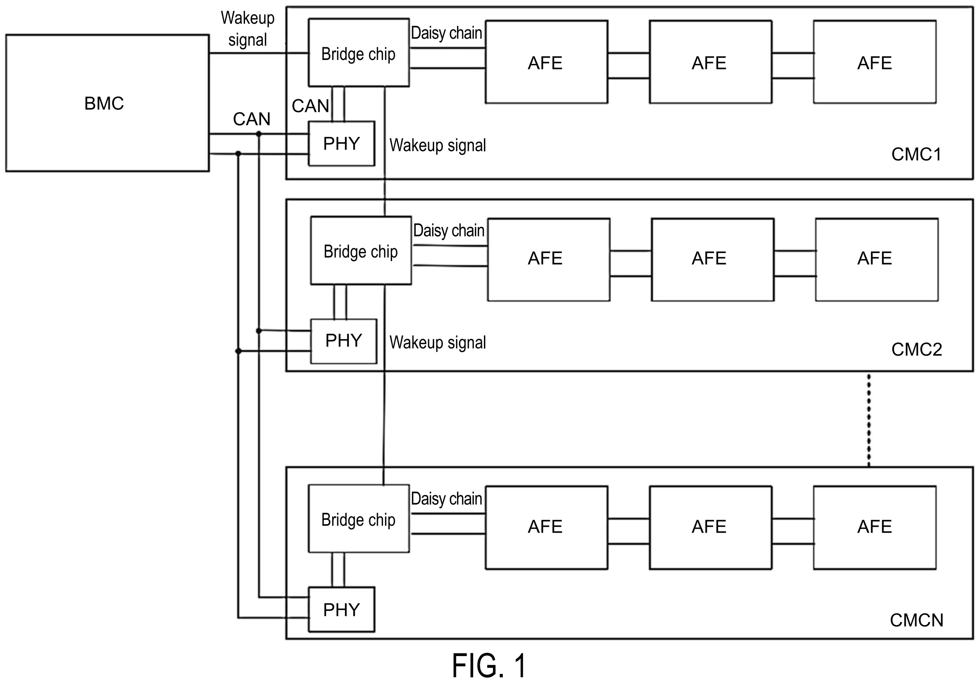

FIG. 1 is a structural schematic diagram of a battery management system provided in an exemplary embodiment of the present disclosure.

The battery management system includes: a battery management control panel BMC and at least two battery cell sampling control panels CMC (CMC1-CMCN). The battery management control panel BMC is connected with each of the battery cell sampling control panels CMC respectively, and each of the battery cell sampling control panels CMC includes a bridge chip.

The battery management control panel BMC is configured to send a first level signal to a GPIO port of the bridge chip included in the battery cell sampling control panel CMC to change an ID status of an ID port of the battery cell sampling control panel CMC. The first level signal sent by the battery management control panel BMC to each of the battery cell sampling control panels CMC is different from one another. The ID status represents a unique identifier of the battery cell sampling control panel CMC.

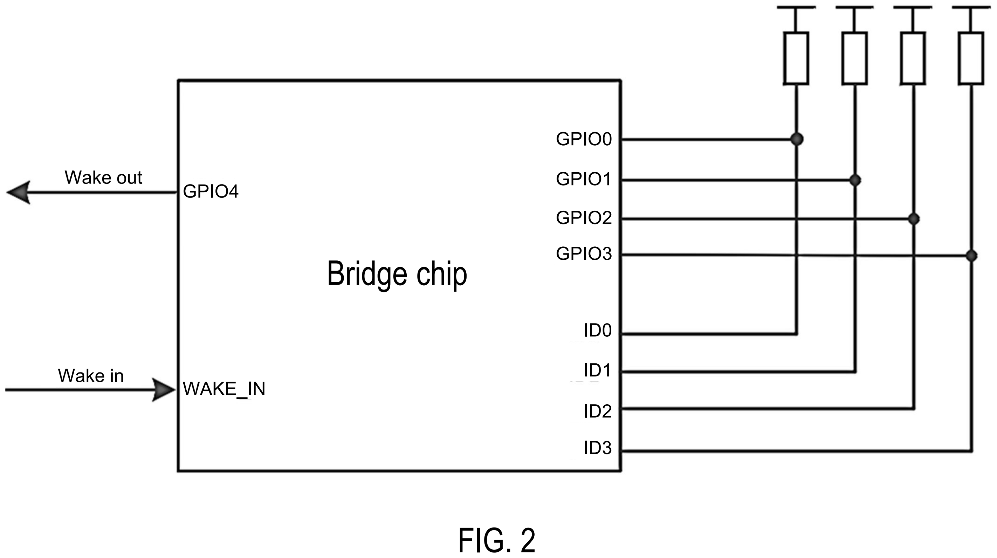

The first level signal is typically a combination of high and low levels, which may be specifically selected according to actual situation, and is not particularly limited herein. Taking the bridge chip with four ID ports shown in FIG. 2 as an example, the ID status is encoded using a four-bit binary format, and the encoding type and number of bits may be specifically set according to actual situation, and are not particularly limited herein. In other implementation methods, the ID status can also be encoded in octal, decimal, hexadecimal, and other formats. The above-mentioned binary format is merely an example, which may be specifically selected according to actual situation, and is not particularly limited herein.

Taking the bridge chip shown in FIG. 2 as an example, the bridge chip includes four ID ports, including ports ID0, ID1, ID2, and ID3, and five GPIO ports, including ports GPIO0, GPIO1, GPIO2, GPIO3, and GPIO4. Ports GPIO0, GPIO1, GPIO2, and GPIO3 are configured to receive the first level signal sent by the battery management control panel BMC. Port GPIO4 is configured to send a wakeup signal to the bridge chip of an adjacent battery cell sampling control panel CMC that has not completely encoded, wherein "wake out" is the sent wakeup signal, a port WAKE_IN is configured to receive the wakeup signal, and "wake in" is the received wakeup signal.

Typically, a bridge chip has four ID ports. The ID ports change the ID status according to the first level signal received by the GPIO ports, so that different battery cell sampling control panels CMC may be distinguished through different ID statuses. If it is necessary to expand more ID ports, multiple bridge chips need to be connected in series, and the number of bridge chips on each of the battery cell sampling control panels CMC may be set according to actual situation, and is not particularly limited herein.

In this embodiment, the battery cell sampling control panel CMC includes the bridge chip. The battery management control panel BMC changes the ID status of the ID port of each of the bridge chips by sending the first level signal. Each of the battery cell sampling control panels CMC may be encoded without having to configure the hardware status of the battery cell sampling control panel CMC, make additional distinction on the hardware of the battery cell sampling control panel CMC, and set an MCU on the battery cell sampling control panel CMC. In this way, it is possible to save both the labor cost of professional technicians configuring the hardware status and the manufacturing cost of the battery cell sampling control panel CMC, as well as reduce the error rate of encoding the battery cell sampling control panel CMC, and simultaneously lower the manufacturing cost of the battery management system.

In an embodiment, the battery management control panel BMC is connected with each of the battery cell sampling control panels CMC respectively through a CAN bus. The battery management control panel BMC sends the first level signal to the GPIO port of the bridge chip contained in the battery cell sampling control panel CMC through the CAN bus.

In this embodiment, utilizing CAN bus communication with a high communication rate and a high data transmission efficiency is more suitable for large-scale battery packs and complex monitoring and control requirements. There is no need to set additional addressing signal lines, which simplifies the wiring and architecture of the battery management system.

In an embodiment, the battery management control panel BMC is also connected with one battery cell sampling control panel CMC through a wakeup signal line. After the battery management control panel BMC sends a wakeup signal to the bridge chip of the battery cell sampling control panel CMC connected with the battery management control panel BMC through the wakeup signal line, the battery management control panel BMC sends the first level signal to the bridge chip of the awakened battery cell sampling control panel CMC.

Before encoding the battery cell sampling chips, all battery cell sampling chips are in an unawakened status. If encoding of the battery cell sampling chips is to be started, the battery management control panel BMC has to send a wakeup signal to the bridge chip of the battery cell sampling control panel CMC through the wakeup signal line to wake up the battery cell sampling control panel CMC.

After the battery cell sampling control panel CMC is awakened, the battery management control panel BMC sends the first level signal to the bridge chip of the corresponding battery cell sampling control panel CMC to encode the battery cell sampling control panel CMC.

In this embodiment, when encoding is not required, the battery cell sampling control panel CMC may be set to a low power consumption mode or a sleep mode. When encoding is required, the battery cell sampling control panels CMC may be awakened one by one through the wakeup signal, thereby reducing unnecessary energy consumption.

In an embodiment, two adjacent battery cell sampling control panels CMC are connected through the wakeup signal line. After the battery management control panel BMC sends the wakeup signal to the bridge chip of one battery cell sampling control panel CMC among other battery cell sampling control panels CMC through the wakeup signal line, the battery management control panel BMC sends the first level signal to the bridge chip of the awakened battery cell sampling control panel CMC.

The other battery cell sampling control panels CMC are battery cell sampling control panels CMC among the at least two battery cell sampling control panels CMC except the battery cell sampling control panel CMC connected with the battery management control panel BMC.

After one battery cell sampling control panel CMC is awakened and completely encoded, the battery management control panel BMC controls the battery cell sampling control panel CMC that has completely encoded, such that the battery cell sampling control panel CMC that has been completely encoded sends the wakeup signal to the bridge chip of the adjacent battery cell sampling control panel CMC that has not been completely encoded through the wakeup signal line to wake up another battery cell sampling control panel CMC.

Taking the battery management system shown in FIG. 1 as an example, the encoding process is further described. To encode a first battery cell sampling control panel CMC1, specifically, the battery management control panel BMC sends the wakeup signal to a bridge chip of the first battery cell sampling control panel CMC1 to wake up the first battery cell sampling control panel CMC1. The battery management control panel BMC sends the first level signal to a physical layer (PHY) chip of the first battery cell sampling control panel CMC1 through the CAN bus, then the PHY chip preprocesses the first level signal and sends the preprocessed first level signal to a GPIO port of the bridge chip of the first battery cell sampling control panel CMC1. The bridge chip changes the ID status of the ID port according to the first level signal received by the GPIO port to encode the first battery cell sampling control panel CMC1.

After the first battery cell sampling control panel CMC1 is completely encoded, the battery management control panel BMC sends the wakeup signal to a bridge chip of a second battery cell sampling control panel CMC2 through the first battery cell sampling control panel CMC1 to wake up the second battery cell sampling control panel CMC2. After the second battery cell sampling control panel CMC2 is awakened, the second battery cell sampling control panel CMC2 is encoded. After the second battery cell sampling control panel CMC2 is completely encoded, the battery management control panel BMC sends the wakeup signal to a bridge chip of a third battery cell sampling control panel CMC3 through the second battery cell sampling control panel CMC2 to wake up the third battery cell sampling control panel CMC3, and the third battery cell sampling control panel CMC3 is encoded. The above steps are executed cyclically until all battery cell sampling control panels CMC are completely encoded.

In this embodiment, two adjacent battery cell sampling control panels CMC are connected through the wakeup signal line. Each of the battery cell sampling control panels CMC may be configured to wake up the next battery cell sampling control panel CMC, thereby realizing an automatic chain wakeup and improving the orderliness of the wake-up process.

In an embodiment, the battery cell sampling control panel CMC is configured to feed back a unique identifier to the battery management control panel BMC through the CAN bus. The battery management control panel BMC is further configured to store the ID status fed back by the battery cell sampling control panel CMC.

The battery management control panel BMC may distinguish different battery cell sampling control panels CMC through the ID status fed back by the battery cell sampling control panel CMC.

In this embodiment, the battery cell sampling control panel CMC is able to store the ID status fed back by the battery cell sampling control panel CMC. When it is required to send a signal to a battery cell sampling control panel CMC, the stored ID status may be directly obtained, thereby accurately achieving signal transmission.

In an embodiment, before sending the first level signal to the GPIO port of the bridge chip contained in the battery cell sampling control panel CMC, the battery management control panel BMC is further configured to send a same second level signal to the GPIO port of the bridge chip contained in each of the battery cell sampling control panels CMC to initialize the ID status of the ID port of each of the battery cell sampling control panels CMC.

The second level signal may be a high-level signal or may be a low-level signal, which may be specifically selected according to the actual situation, and is not particularly limited herein. The ID status of the ID port of each of the battery cell sampling control panels CMC after initialization is the same, which may all be at a high-level status, or may all be at a low-level status, the status may be specifically set according to the actual situation, and is not particularly limited herein.

In this embodiment, by sending the same second level signal to the GPIO port of the bridge chip contained in each of the battery cell sampling control panels CMC to initialize the ID status of the ID port of each of the battery cell sampling control panels CMC, it is easy to identify the battery cell sampling control panels CMC that have completely encoded and the battery cell sampling control panels CMC that have not been completely encoded, thus improving the accuracy of encoding.

In an embodiment, in response to the duplication of the ID status fed back by the battery cell sampling control panel CMC, the battery management control panel BMC re-executes the step of sending the first level signal to the GPIO port of the bridge chip contained in the battery cell sampling control panel CMC, thereby realizing re-encoding of the battery cell sampling control panel CMC.

If multiple battery cell sampling control panels CMC have the same ID status, it is difficult to distinguish different battery cell sampling control panels CMC, and it cannot be ensured that the signal sent by the battery management control panel BMC can be received by the correct battery cell sampling control panel CMC, which will cause data transmission errors. Therefore, it is required to re-encode the battery cell sampling control panels CMC, re-encoding may ensure that each of the battery cell sampling control panels CMC has a unique ID status to ensure accurate data transmission.

In this embodiment, if there is duplication of the ID status fed back by different battery cell sampling control panels CMC, the step of sending the first level signal to the GPIO port of the bridge chip contained in the battery cell sampling control panel CMC is re-executed to ensure accurate data transmission and improve communication reliability.

In an embodiment, referring to FIG. 1, the battery management system further includes: a battery sampling chip AFE, and multiple battery sampling chips AFE adopt daisy chain communication between them.

The number of battery sampling chips AFE may be set according to the actual situation, and is not particularly limited herein.

In this embodiment, daisy chain communication only requires two signal lines to pass through all nodes. In comparison with other communication methods such as CAN bus, the daisy chain communication has a lower wiring complexity and cost. Furthermore, daisy chain communication employs a series connection method whereby only short-distance communication lines are required between each node and adjacent nodes. Consequently, the interference from external noise is minimal, and the reliability is high.

In an embodiment, the battery cell sampling control panel CMC includes a PHY chip. Both the bridge chip of the battery cell sampling control panel CMC and the battery management control panel BMC are connected to the PHY chip.

The PHY chip is configured to preprocess a CAN signal sent by the battery management control panel BMC, so that the CAN signal is suitable for transmission on the bridge chip.

In this embodiment, the PHY chip is configured to preprocess the CAN signal, adapt the CAN signal to a signal form suitable for conversion, so that the CAN signal is suitable for transmission on the bridge chip, thus improving the accuracy of signal transmission.

### Embodiment 2

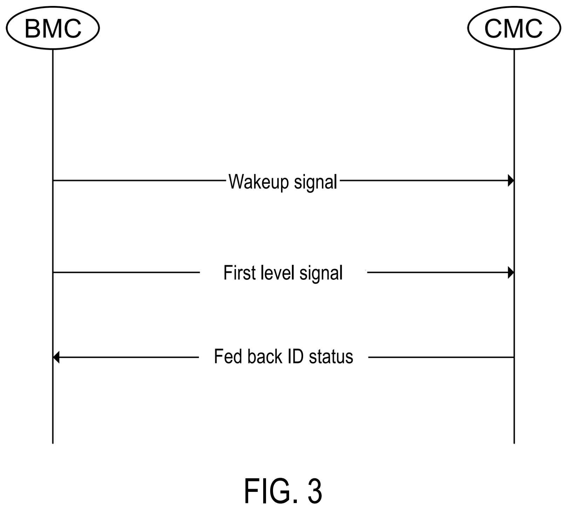

This embodiment also provides an encoding method for a battery management system, which is applied to a battery management control panel BMC contained in the battery management system. The battery management system further includes: at least two battery cell sampling control panels CMC. The battery management control panel BMC is connected to each of the battery cell sampling control panels CMC respectively. Referring to FIG. 3, the encoding method includes: sending, by the battery management control panel BMC, the first level signal to the GPIO port of the bridge chip contained in the battery cell sampling control panel CMC to change the ID status of the ID port of the battery cell sampling control panel CMC.

Wherein, the first level signal sent by the battery management control panel BMC to each of the battery cell sampling control panels CMC is different from one another. The ID status represents a unique identifier of the battery cell sampling control panel CMC.

The first level signal may be a high-level signal or a low-level signal, which may be specifically selected according to the actual situation, and is not particularly limited here. The unique identifier is usually encoded in a four-bit binary format, and the encoding type and number of bits may be specifically set according to the actual situation, and are not particularly limited here.

Normally a bridge chip has four ID ports, the ID ports change ID status according to the first level signal received by the GPIO port, so that different battery cell sampling control panels CMC can be distinguished through different ID statuses. If more ID ports need to be expanded, multiple bridge chips need to be connected in series, and the number of bridge chips on each of the battery cell sampling control panels CMC may be set according to the actual situation, and is not particularly limited here.

In this embodiment, the battery cell sampling control panel CMC includes a bridge chip. The battery management control panel BMC changes the ID status of the ID port of each of the bridge chips by sending the first level signal. Each of the battery cell sampling control panels CMC may be encoded without having to configure the hardware status of the battery cell sampling control panel CMC, make additional distinction on the hardware of the battery cell sampling control panel CMC, and set an MCU on the battery cell sampling control panel CMC. In this way, it is possible to save both the labor cost of professional technicians configuring the hardware status and the manufacturing cost of the battery cell sampling control panel CMC, as well as reduce the error rate of encoding the battery cell sampling control panel CMC, and simultaneously lower the manufacturing cost of the battery management system.

In an embodiment, the battery management control panel BMC sends the first level signal to the GPIO port of the bridge chip contained in the battery cell sampling control panel CMC to change the ID status of the ID port of the battery cell sampling control panel CMC, and the step specifically includes: sending the first level signal to the GPIO port of the bridge chip contained in the battery cell sampling control panel CMC through the CAN bus.

In this embodiment, utilizing CAN bus communication with a high communication rate and a high data transmission efficiency is more suitable for large-scale battery packs and complex monitoring and control requirements without requiring additional encoding signal lines, which simplifies the wiring and architecture of the battery management system.

In an embodiment, the battery management control panel BMC sends the first level signal to the GPIO port of the bridge chip contained in the battery cell sampling control panel CMC to change the ID status of the ID port of the battery cell sampling control panel CMC, and the step includes: sending the same second level signal to the GPIO port of the bridge chip contained in the battery cell sampling control panel CMC to initialize the ID status of the ID port of each of the battery cell sampling control panels CMC; sequentially sending the first level signal to the GPIO port of the bridge chip contained in the battery cell sampling control panel CMC.

The second level signal may be a high-level signal or a low-level signal, which may be specifically selected according to the actual situation, and is not particularly limited here. The ID status of the ID port of each of the battery cell sampling control panels CMC after initialization is the same, which may all be at a high-level status, or may all be at a low-level status, the status may be specifically set according to the actual situation, and is not particularly limited herein.

In this embodiment, by sending the same second level signal to the GPIO port of the bridge chip contained in each of the battery cell sampling control panels CMC to initialize the ID status of the ID port of each of the battery cell sampling control panels CMC, it is possible to effectively avoid the error rate of encoding the battery cell sampling control panel CMC, and improve the accuracy of encoding.

In an embodiment, the battery management control panel BMC sends the first level signal to the GPIO port of the bridge chip contained in the battery cell sampling control panel CMC to change the ID status of the ID port of the battery cell sampling control panel CMC, and the step includes: sequentially waking up one bridge chip, sending the first level signal to the GPIO port of the bridge chip contained in the awakened battery cell sampling control panel CMC.

Before encoding the battery cell sampling chips, all battery cell sampling chips are in an unawakened status. If encoding of the battery cell sampling chips is to be started, the battery management control panel BMC has to send a wakeup signal to the bridge chip of the battery cell sampling control panel CMC through the wakeup signal line to wake up the battery cell sampling control panel CMC.

After the battery cell sampling control panel CMC is awakened, the battery management control panel BMC sends the first level signal to the bridge chip of the corresponding battery cell sampling control panel CMC to encode the battery cell sampling control panel CMC.

In this embodiment, when encoding is not required, the battery cell sampling control panel CMC may be set to a low power consumption mode or a sleep mode. When encoding is required, the battery cell sampling control panels CMC may be awakened one by one through the wakeup signal, thereby reducing unnecessary energy consumption.

In an embodiment, the encoding method further includes: the battery management control panel BMC receives the ID status fed back by each of the battery cell sampling control panels CMC, in response to the presence of the same ID status, the battery management control panel BMC re-executes the step of sending the first level signal to the GPIO port of the bridge chip included in the battery cell sampling control panel CMC.

If multiple battery cell sampling control panels CMC have the same ID status, it cannot be ensured that the signal sent by the battery management control panel BMC can be received by the correct battery cell sampling control panel CMC, which may cause data transmission errors. Therefore, the battery cell sampling control panel CMC needs to be re-encoded, re-encoding can ensure that each of the battery cell sampling control panels CMC has a unique ID status to ensure accurate data transmission.

In this embodiment, if there is duplication of the ID status of ID ports of different battery cell sampling control panels CMC, the step of sending the first level signal to the GPIO port of the bridge chip contained in the battery cell sampling control panel CMC is re-executed to ensure accurate data transmission and improve communication reliability.

In an embodiment, daisy chain communication is adopted between multiple battery sampling chips AFE.

In this embodiment, daisy chain communication only requires two signal lines to pass through all nodes. In comparison with other communication methods such as CAN bus, the daisy chain communication has a lower wiring complexity and cost. Furthermore, daisy chain communication employs a series connection method whereby only short-distance communication lines are required between each node and adjacent nodes. Consequently, the interference from external noise is minimal, and the reliability is high.

In an embodiment, the battery cell sampling control panel CMC includes the PHY chip. The bridge chip of the battery cell sampling control panel CMC and the battery management control panel BMC are both connected with the PHY chip.

The PHY chip is configured to preprocess the CAN signal sent by the BMC, making the CAN signal suitable for transmission on the bridge chip.

In this embodiment, the PHY chip is configured to preprocess the CAN signal, adapt the CAN signal to a signal form suitable for conversion, making the CAN signal suitable for transmission on the bridge chip, thus improving the accuracy of signal transmission.

### Embodiment 3

This embodiment also provides an encoding method of a battery management system. The encoding method of the battery management system is applied to a battery cell sampling control panel CMC contained in the battery management system. The battery cell sampling control panel CMC includes a bridge chip. The battery management system further includes: a battery management control panel BMC. The battery management control panel BMC is connected with the battery cell sampling control panel CMC. Referring to FIG. 3, the encoding method includes: receiving, by a GPIO port of the bridge chip, a first level signal sent by the battery management control panel BMC to change an ID status of an ID port of the bridge chip.

The first level signal sent by the battery management control panel BMC to each of the battery cell sampling control panel CMC in at least two battery cell sampling control panels CMC contained in the battery management system is different from one another. The ID status represents a unique identifier of the battery cell sampling control panel CMC.

In this embodiment, the battery cell sampling control panel CMC includes the bridge chip. The battery management control panel BMC changes the ID status of the ID port of each of the bridge chips by sending the first level signal. Each of the battery cell sampling control panels CMC may be encoded without having to configure the hardware status of the battery cell sampling control panel CMC, make additional distinction on the hardware of the battery cell sampling control panel CMC, and set an MCU on the battery cell sampling control panel CMC. In this way, it is possible to save both the labor cost of professional technicians configuring the hardware status and the manufacturing cost of the battery cell sampling control panel CMC, as well as reduce the error rate of encoding the battery cell sampling control panel CMC, and simultaneously lower the manufacturing cost of the battery management system.

In an embodiment, the encoding method further includes the following steps:

Feeding back the ID status to the battery management control panel BMC, so that the battery management control panel BMC stores the ID status.

The battery management control panel BMC may determine whether the ID status matches the unique identifier through the unique identifier fed back by the battery cell sampling control panel CMC.

In this embodiment, the battery cell sampling control panel CMC is able to store the ID status fed back by the battery cell sampling control panel CMC. When it is required to send a signal to a battery cell sampling control panel CMC, the stored ID status may be directly obtained, thereby accurately achieving signal transmission.

### Embodiment 4

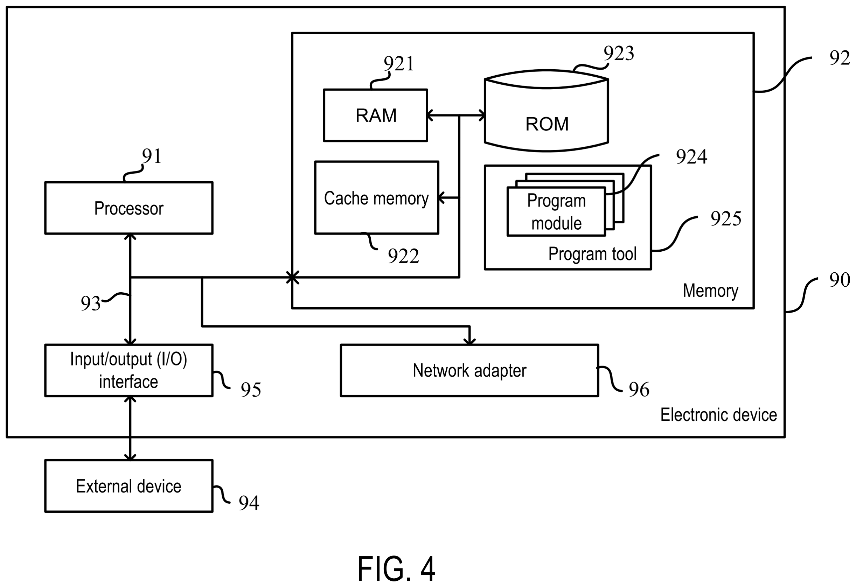

FIG. 4 is a structural schematic diagram of an electronic device shown in an example embodiment of the present disclosure. The electronic device includes a memory, a processor and a computer program stored in the memory and configured for running on the processor. The processor implements the encoding method of the battery management system in any of the above embodiments when executing the computer program. The electronic device 90 shown in FIG. 4 is merely an example, and should not bring any limitation to the function and use scope of the embodiments of the present disclosure.

As shown in FIG. 4, an electronic device 90 may be represented in the form of a general computing device, for example, the electronic device 90 may be a server device. The components of the electronic device 90 may include but are not limited to: the at least one processor 91, the at least one memory 92, and a bus 93 connecting different system components (including the memory 92 and the processor 91).

The bus 93 includes a data bus, an address bus and a control bus.

The memory 92 may include a volatile memory, such as a random access memory (RAM) 921 and/or a cache memory 922, and may further include a read-only memory (ROM) 923.

The memory 92 may also include a program tool 925 (or utility) having a set (at least one) of program modules 924, such program modules 924 include but are not limited to: operating systems, one or more application programs, other program modules, and program data. Each of these examples or some combinations thereof may include implementation of a network environment.

The processor 91 executes various functional applications and data processing by running computer programs stored in the memory 92, such as the encoding method of the battery management system provided in any of the above embodiments.

The electronic device 90 may also communicate with one or more external devices 94 (for example, keyboard, pointing device, etc.). This communication may be performed through an input/output (I/O) interface 95. Moreover, the electronic device 90 may also communicate with one or more networks (for example, a local area network (LAN), a wide area network (WAN) and/or a public network, for example, Internet) through a network adapter 96. As shown in the figure, the network adapter 96 communicates with other modules of the electronic device 90 through the bus 93. It should be understood that, although not shown in the figure, other hardware and/or software modules may be used in combination with the electronic device 90, including but not limited to: microcode, device drivers, redundant processors, external disk drive arrays, RAID (disk array) systems, tape drives, and data backup storage systems, etc.

It should be noted that, although several units/modules or sub-units/modules of the electronic device are mentioned in the above detailed description, such categorization is merely exemplary and not mandatory. Actually, according to the embodiments of the present disclosure, the features and functions of two or more units/modules described above may be embodied in one unit/module. Conversely, the features and functions of one unit/module described above may be further classified to be embodied by multiple units/modules.

### Embodiment 5

The embodiments of the present disclosure also provide a computer-readable storage medium having a computer program stored therein. When the program is executed by a processor, the encoding method of the battery management system provided in any of the above embodiments is implemented.

The readable storage medium may more specifically include but is not limited to: a portable disk, a hard disk, a random access memory, a read-only memory, an erasable programmable read-only memory, an optical storage device, a magnetic storage device, or any suitable combination of the above.

### Embodiment 6

The embodiments of the present disclosure also provide a computer program product, including a computer program. When the computer program is executed by a processor, the encoding method of the battery management system in any of the above embodiments is implemented.

The program code for executing the computer program product of the present disclosure may be written in any combination of one or more programming languages. The program code may be executed entirely on a user equipment, partially on the user equipment, as an independent software package, partially on the user equipment and partially on a remote equipment, or entirely on the remote equipment.

Although the specific embodiments of the present disclosure have been described above, those skilled in the art should understand that these are merely illustrative examples, and the scope to be protected by the present disclosure is limited by the appended claims. Those skilled in the art may make various changes or modifications to these embodiments without departing from the principles and essence of the present disclosure, but these changes and modifications all fall within the scope to be protected by the present disclosure.

### [REFERENCE SIGNS LIST]

90: electronic device
91: processor
92: memory
93: bus
94: external device
95: input/output (I/O) interface
96: network adapter
921: RAM
922: cache memory
923: ROM
924: program module
925: program tool
AFE: battery sampling chip
BMC: battery management control panel
CMC, CMC1-CMCN: battery cell sampling control panel
GPIO0-GPIO4: port
ID0-ID3: port
WAKE_IN: port

## Claims

1. A battery management system, comprising: a battery management control panel (BMC) and at least two battery cell sampling control panels (CMC, CMC1-CMCN), wherein the battery management control panel (BMC) is connected to each of the battery cell sampling control panels (CMC, CMC1-CMCN) respectively, and each of the battery cell sampling control panels (CMC, CMC1-CMCN) comprises a bridge chip;
wherein the battery management control panel (BMC) is configured to send a first level signal to a general-purpose input/output (GPIO) port (GPIO0-GPI04) of the bridge chip contained in each of the battery cell sampling control panels (CMC, CMC1-CMCN) to change an identification (ID) status of an ID port of each of the battery cell sampling control panels (CMC, CMC1-CMCN); the first level signal sent by the battery management control panel (BMC) to the each of the battery cell sampling control panels (CMC, CMC1-CMCN) is different from one another, and the ID status represents a unique identifier of each of the battery cell sampling control panels (CMC, CMC1-CMCN).

2. The battery management system according to claim 1, wherein the battery management control panel (BMC) is connected to each of the battery cell sampling control panels (CMC, CMC1-CMCN) respectively through a controller area network (CAN) bus, the battery management control panel (BMC) sends the first level signal to the GPIO port (GPIO0-GPIO4) of the bridge chip contained in each of the battery cell sampling control panels (CMC, CMC1-CMCN) through the CAN bus.

3. The battery management system according to claim 1, wherein the battery management control panel (BMC) is further connected to one of the battery cell sampling control panels (CMC, CMC1-CMCN) through a wakeup signal line, after the battery management control panel (BMC) sends a wakeup signal to the bridge chip of one of the battery cell sampling control panels (CMC, CMC1-CMCN) connected to the battery management control panel (BMC) through the wakeup signal line, the battery management control panel (BMC) sends the first level signal to the bridge chip of one of the battery cell sampling control panel (CMC, CMC1-CMCN) which is awakened;
and/or, two of the battery cell sampling control panels (CMC, CMC1-CMCN), which are adjacent, are connected through another wakeup signal line, after the battery management control panel (BMC) sends another wakeup signal to the bridge chip of one of the other battery cell sampling control panels (CMC, CMC1-CMCN) through the another wakeup signal line, the battery management control panel (BMC) sends the first level signal to the bridge chip of one of the battery cell sampling control panel (CMC, CMC1-CMCN) which is awakened; wherein the other battery cell sampling control panels (CMC, CMC1-CMCN) are battery cell sampling control panels (CMC, CMC1-CMCN) among the at least two battery cell sampling control panels (CMC, CMC1-CMCN) except the battery cell sampling control panel (CMC, CMC1-CMCN) connected to the battery management control panel (BMC).

4. The battery management system according to claim 2, wherein each of the battery cell sampling control panels (CMC, CMC 1-CMCN) is configured to feed back the ID status to the battery management control panel (BMC) through the CAN bus, the battery management control panel (BMC) is further configured to store the ID status fed back by each of the battery cell sampling control panels (CMC, CMC1-CMCN);
and/or, before sending the first level signal to the GPIO port (GPIO0-GPI04) of the bridge chip contained in each of the battery cell sampling control panels (CMC, CMC1-CMCN), the battery management control panel (BMC) is further configured to send a same second level signal to the GPIO port (GPIO0-GPI04) of the bridge chip contained in each of the battery cell sampling control panels (CMC, CMC1-CMCN) to initialize the ID status of the ID port of each of the battery cell sampling control panels (CMC, CMC1-CMCN).

5. The battery management system according to claim 1, wherein in response to duplication of the ID status fed back by each of the battery cell sampling control panels (CMC, CMC1-CMCN), the battery management control panel (BMC) re-executes step of sending the first level signal to the GPIO port (GPIO0-GPI04) of the bridge chip contained in each of the battery cell sampling control panels (CMC, CMC1-CMCN) to achieve re-encoding of each of the battery cell sampling control panels (CMC, CMC1-CMCN).

6. An encoding method for a battery management system, which is applied to a battery management control panel (BMC) contained in the battery management system, wherein the battery management system further comprises: at least two battery cell sampling control panels (CMC, CMC1-CMCN), the battery management control panel (BMC) is connected to each of the battery cell sampling control panels (CMC, CMC1-CMCN) respectively, the encoding method comprises:
sending a first level signal to a general-purpose input/output (GPIO) port of a bridge chip contained in each of the battery cell sampling control panels (CMC, CMC1-CMCN) to change an identification (ID) status of an ID port of each of the battery cell sampling control panels (CMC, CMC1-CMCN);
wherein the first level signal sent to each of the battery cell sampling control panels (CMC, CMC1-CMCN) is different from one another, the ID status represents a unique identifier of each of the battery cell sampling control panels (CMC, CMC1-CMCN).

7. The encoding method for the battery management system according to claim 6, wherein step of sending the first level signal to the GPIO port (GPIO0-GPI04) of the bridge chip contained in each of the battery cell sampling control panels (CMC, CMC1-CMCN) comprises: sending a same second level signal to the GPIO port (GPIO0-GPI04) of the bridge chip contained in each of the battery cell sampling control panels (CMC, CMC 1-CMCN) to initialize the ID status of the ID port of each of the battery cell sampling control panels (CMC, CMC1-CMCN); sequentially sending the first level signal to the GPIO port (GPIO0-GPI04) of the bridge chip contained in each of the battery cell sampling control panels (CMC, CMC1-CMCN);
and/or, step of sending the first level signal to the GPIO port (GPIO0-GPI04) of the bridge chip contained in each of the battery cell sampling control panels (CMC, CMC1-CMCN) comprises: sequentially waking up one bridge chip, sending the first level signal to the GPIO port (GPIO0-GPIO4) of the woken bridge chip contained in each of the battery cell sampling control panels (CMC, CMC1-CMCN);
and/or, the encoding method further comprises: receiving the ID status fed back by each of the battery cell sampling control panels (CMC, CMC1-CMCN), in response to presence of a same ID status, re-executing step of sending the first level signal to the GPIO port (GPIO0-GPIO4) of the bridge chip contained in each of the battery cell sampling control panels (CMC, CMC1-CMCN).

8. An encoding method for a battery management system, which is applied to a battery cell sampling control panel (CMC, CMC1-CMCN) contained in the battery management system, the battery cell sampling control panel (CMC, CMC1-CMCN) comprising a bridge chip, wherein the battery management system further comprises: a battery management control panel (BMC), the battery management control panel (BMC) is connected to the battery cell sampling control panel (CMC, CMC1-CMCN), the encoding method comprises:
receiving, by a general-purpose input/output (GPIO) port of the bridge chip, a first level signal sent by the battery management control panel (BMC) to change an identification (ID) status of an ID port (ID0-ID3) of the bridge chip;
wherein the first level signal sent by the battery management control panel (BMC) to each of at least two of the battery cell sampling control panels (CMC, CMC1-CMCN) contained in the battery management system is different from one another, the ID status represents a unique identifier of each of the battery cell sampling control panels (CMC, CMC1-CMCN).

9. The encoding method for the battery management system according to claim 8, further comprising:
feeding back the ID status to the battery management control panel (BMC), so that the battery management control panel (BMC) stores the ID status.

10. An electronic device, comprising a memory (92), a processor (91), and a computer program stored in the memory (92) and configured for running on the processor (91), wherein the processor (91) implements the encoding method for the battery management system according to any one of claims 6 to 9 when executing the computer program.
